# FASCICULE DE BREVET EUROPEEN

(11) **EP 0 454 597 B1**
(45) Date de publication et mention de la délivrance du brevet: **11.12.1996**
(21) Numéro de dépôt: 91420131.4
(22) Date de dépôt: 22.04.1991
(51) Int. Cl.: H03K 17/691

(54) **Circuit de commande de grille par impulsion avec securité de court-circuit**
Impuls-Gate-Steuerschaltung mit Kurzschlusssicherung
Pulse gate control circuit with short-circuit protection

(30) Priorité: 25.04.1990 FR 9005692
(43) Date de publication de la demande: 30.10.1991
(73) Titulaire: SGS-THOMSON MICROELECTRONICS S.A., 94250 Gentilly (FR)
(72) Inventeur: Bourgeois, Jean-Marie, F-13830 La Bedoule (FR)
(74) Mandataire: de Beaumont, Michel

(56) Documents cités:
- EP-A- 0 268 930
- NL-A- 8 801 996
- PATENT ABSTRACTS OF JAPAN, vol. 11, no. 92 (E-491)[2539], 24 mars 1987; & JP-A-61 242 416

## Description

La présente invention concerne la commande de transistors de puissance à commande capacitive tels que les transistors MOS et les transistors bipolaires à grille isolée (IGBT).

Plus particulièrement, la présente invention vise à réaliser une commande permettant un isolement entre le circuit de commande et le circuit de puissance, une brève impulsion pouvant entraîner la mise en conduction du transistor de puissance jusqu'à fourniture d'une brève impulsion de polarité opposée pour ouvrir ce transistor de puissance.

Un objet de la présente invention est de prévoir un tel circuit qui soit particulièrement simple, qui puisse fonctionner à faible fréquence sans limitation de rapport cyclique et qui permette une commutation rapide du transistor de puissance.

Un autre objet de la présente invention est de prévoir un tel circuit de commande comprenant un moyen d'interruption de la conduction du transistor de puissance en cas de court-circuit dans la charge.

Un autre objet de la présente invention est de prévoir un tel circuit de commande comprenant des moyens pour fournir vers la partie du circuit de commande isolée du circuit de puissance une indication du fait qu'un court-circuit est survenu dans la charge.

Un circuit de commande de grille selon la préambule de la revendication 1 est connu de JP-A-61 242 416.

Pour atteindre ces objets ainsi que d'autres, la présente invention prévoit un circuit de commande par impulsions d'un transistor de puissance à grille isolée comprenant une première borne, de grille, et une deuxième borne, de référence, un transistor MOS auxiliaire étant connecté entre lesdites première et deuxième bornes, un secondaire de transformateur d'impulsions ayant des troisième et quatrième bornes étant relié aux première et deuxième bornes. Ce circuit comprend une première diode connectée entre les deuxième et quatrième bornes, et deux voies en parallèle à conduction unidirectionnelle commandée, entre la quatrième borne et la grille du transistor auxiliaire, l'une de ces voies étant rendue passante quand une impulsion positive ou négative est appliquée sur le secondaire du transformateur. Chacune desdites voies comprend respectivement une deuxième et une troisième diode en série avec un premier et un deuxième transistor MOS, les deux diodes étant connectées en anti-parallèle, les deux transistors MOS étant de canal de type de conductivité opposé, leurs grilles étant interconnectées et reliées à ladite troisième borne.

Selon un aspect de la présente invention, il est prévu des moyens d'interruption de la conduction du transistor de puissance quand sa charge est en court-circuit, ces moyens comprenant un chemin en parallèle avec ladite première diode, ce chemin étant mis en conduction quand le courant dans le transistor de puissance dépasse une intensité prédéterminée ou que la chute de tension à l'état passant dans le transistor de puissance dépasse une valeur prédéterminée.

Selon un aspect de la présente invention, il est prévu des moyens d'inhibition de la mise en conduction dudit chemin pendant la charge de la grille du transistor de puissance.

Selon un aspect de la présente invention, le primaire dudit transformateur est associé à un circuit de détection de passage d'une impulsion de décharge de capacité grille/électrode du transistor de puissance dans le secondaire du transformateur par suite de la fermeture dudit chemin.

Ces objets, caractéristiques et avantages ainsi que d'autres de la présente invention seront exposés plus en détail dans la description suivante de modes de réalisation particuliers faite en relation avec les figures jointes parmi lesquelles :
Les figures 1 et 2 représentent un même mode de réalisation de la présente invention, respectivement pendant l'application d'un ordre de fermeture et pendant l'application d'un ordre d'ouverture;
la figure 3 représente un circuit identique à celui des figures 1 et 2, avec adjonction de moyens d'interruption de la conduction du transistor principal pendant un court-circuit ; et
la figure 4 représente un exemple de montage de circuit de commande associé au primaire d'un transformateur d'impulsions utilisé selon la présente invention.

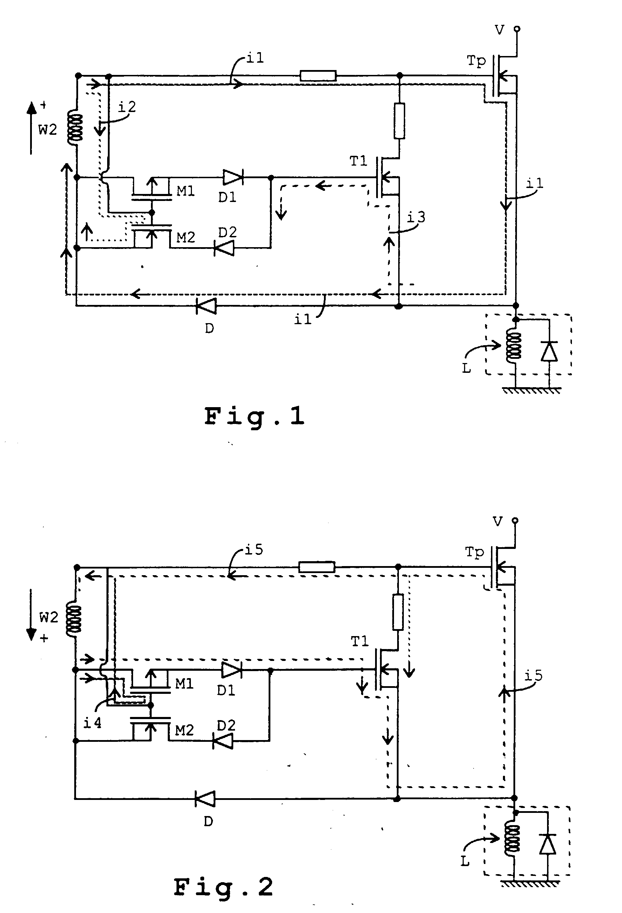

Les figures 1 et 2 représentent un mode de réalisation particulier de la présente invention. De façon générale, la présente invention concerne la commande en commutation d'un transistor de puissance ou transistor principal Tp dont une première borne principale est reliée à une tension d'alimentation V et dont l'autre borne principale, ou borne de référence est reliée à une charge L, qui est couramment une charge inductive en parallèle sur une diode roue libre.

Selon la présente invention, il est prévu des moyens pour mettre le transistor Tp en conduction quand une impulsion d'une première polarité arrive sur un enroulement secondaire W2 d'un transformateur et pour ouvrir ce transistor principal Tp quand une impulsion d'une seconde polarité est appliquée sur l'enroulement W2. Un transistor auxiliaire T1 est connecté entre la grille et l'électrode de référence du transistor Tp. L'état de conduction du transistor T1 est commandé pour être complémentaire de celui du transistor Tp. Ainsi, quand le transistor Tp est ouvert, le transistor T1 est fermé pour évacuer toute charge parasite susceptible d'apparaître sur la grille du transistor Tp et, quand le transistor Tp est passant, le transistor T1 est ouvert pour éviter de décharger la grille du transistor Tp.

En outre, la présente invention prévoit des moyens pour assurer une circulation unidirectionnelle du courant lors d'une opération de fermeture pour charger la grille du transistor Tp et décharger la grille du transistor T1 et pour que ces grilles restent dans cet état jusqu'à l'apparition d'une impulsion de polarité opposée.

L'homme de l'art pourra imaginer divers moyens pour assurer une telle transmission unidirectionnelle d'impulsions apparaissant sur le secondaire W2. Un mode de réalisation particulier de ces moyens pour assurer des circulations unidirectionnelles de courant est illustré en figures 1 et 2. Il comprend une diode D connectée entre la borne de référence du transistor T1 et la borne inférieure de l'enroulement secondaire W2. En outre, cette borne inférieure de l'enroulement W2 est reliée à la grille du transistor T1 par deux voies en parallèle comprenant chacune une diode de polarité inverse de celle de la diode de l'autre voie, respectivement D1 et D2. Chaque diode est en série avec un interrupteur, ces deux interrupteurs étant commandés en opposition d'une façon qui sera exposée ci-après.

Dans le mode de réalisation représenté, le transistor de puissance Tp est un transistor MOS à enrichissement à canal N, de même que le transistor auxiliaire T1. Dans les deux voies en parallèle, le premier interrupteur commandé est un transistor MOS à canal P M1 et le deuxième interrupteur commandé est un transistor MOS à canal N M2. Les grilles des transistors M1 et M2 sont interconnectées et reliées à la borne supérieure de l'enroulement secondaire W2. La diode D1 est polarisée de façon à laisser passer un courant positif vers la grille du transistor T1. La diode D2 est polarisée en sens inverse. La diode D est polarisée pour laisser passer un courant positif vers la borne inférieure de l'enroulement secondaire W2.

Dans le cadre du mode de réalisation particulier illustré en figure 1, un ordre de fermeture du transistor Tp correspond à l'application d'une impulsion positive sur l'enroulement secondaire W2, de la façon illustrée. En présence de cette impulsion, un courant i₁ circule de la borne supérieure à la borne inférieure de l'enroulement W2 en passant par la capacité grille/source du transistor Tp et par la diode D. Un courant i₂ circule dans la capacité grille/source du transistor M2 pour le rendre passant (simultanément, le transistor M1 est bloqué). En outre, un courant i₃ dont le cheminement est illustré seulement partiellement décharge la capacité grille/source du transistor auxiliaire T1 (le courant i₃ constitue une dérivation, passant par la diode D2 et le transistor M2 du courant i₁ traversant la diode D).

En outre, en raison de la prévision des diverses diodes illustrées, les transistors Tp et T1 restent dans l'état qu'ils présentent à la fin de l'application de l'impulsion de commande.

La figure 2 illustre l'application d'un ordre d'ouverture du transistor principal Tp. Pour ouvrir le transistor Tp, une impulsion négative est appliquée sur l'enroulement W2. Ainsi, un premier courant i₄ rend passant le transistor M1 (simultanément le transistor M2 est bloqué). Dès que ce transistor M1 est passant, un courant i₅ peut s'écouler à partir de la borne inférieure de l'enroulement secondaire W2 par le transistor M1, la diode D1, la capacité grille/source du transistor T1, la capacité grille/source du transistor Tp, vers la borne supérieure de l'enroulement secondaire W2. On obtient ainsi simultanément une charge de la grille du transistor T1 et une décharge de la grille du transistor Tp, ce qui rend le transistor T1 passant et bloque le transistor Tp. On notera, qu'une fois que le transistor T1 est rendu passant, la grille du transistor Tp peut terminer de se décharger directement à travers le transistor T1 et l'impédance représentée en série.

Le circuit décrit constitue un exemple particulier de circuit de commande par impulsion d'un transistor de puissance, illustré comme étant un transistor MOS à canal N mais pouvant également être un autre type de transistor MOS ou un transistor bipolaire à grille isolée (IGBT). Un avantage de ce circuit de commande par impulsion réside dans sa simplicité et dans le petit nombre de composants qui le constituent. De ce fait, on peut envisager de réaliser ce circuit sous forme intégrée sur la puce comprenant le transistor de puissance (seul l'enroulement secondaire W2 étant extérieur au circuit intégré).

Un autre avantage du circuit décrit précédemment réside dans le fait qu'il peut être associé à un système de détection de mise en court-circuit de la charge, d'interruption de la conduction du transistor de puissance en cas de détection de court-circuit, et de signalisation de la présence d'un tel court-circuit. On notera, comme cela apparaîtra ci-après, qu'il convient de distinguer la fonction d'interruption de conduction lors d'un court-circuit de la fonction de signalisation d'un tel court-circuit. En effet, il existe des circuits permettant une interruption automatique en cas de court-circuit sans signalisation de l'apparition d'une telle interruption. Avec de tels circuits, si le transistor de puissance est destiné à fonctionner de façon cyclique, par exemple dans le cadre de montages en pont ou de circuits convertisseurs, à chaque cycle, un début de conduction sera suivi d'une interruption dans le cas d'un court-circuit dans la charge. Il est alors souhaitable de signaler du côté du primaire du transformateur la présence d'un tel court-circuit pour arrêter la commande de façon à éviter des échauffements anormaux et à améliorer la durée de vie des composants de puissance.

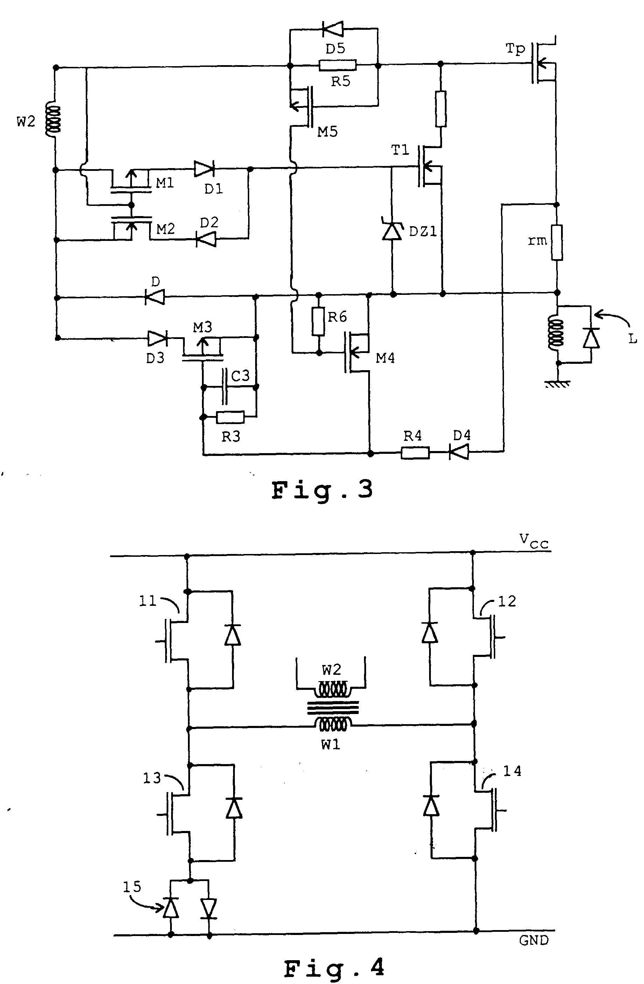

On retrouve en figure 3 les éléments de circuit déjà illustrés en figures 1 et 2, à savoir le transistor Tp, le transistor auxiliaire T1, la charge L, la diode D, la diode D1 et le transistor MOS à enrichissement à canal P M1, la diode D2 et le transistor MOS à enrichissement à canal N M2, et l'enroulement secondaire W2. On a rajouté à ce circuit une résistance rₘ de faible valeur, en série entre la charge et l'électrode de référence du transistor Tp. La tension aux bornes de cette résistance rₘ commande un interrupteur, réalisé dans le cas particulier illustré par un transistor MOS à enrichissement à canal N M3, ce transistor étant disposé en série avec une diode D3, cet ensemble étant en parallèle sur la diode D, les diodes D3 et D étant en anti-parallèle. On notera que, si le transistor M3 est réalisé sous forme d'un transistor bipolaire, la prévision d'une diode D3 est inutile, cette diode étant présente uniquement parce que, dans les technologies couramment utilisées pour réaliser un transistor MOS tel que le transistor M3, il existe en parallèle sur ce transistor une diode (non représentée) de même polarité que la diode D mais, cette diode (non représentée) étant lente, on ne souhaite pas l'utiliser.

Quand le courant dans la charge et la tension sur la résistance rₘ dépassent un seuil prédéterminé, le transistor M3 devient conducteur et la grille du transistor Tp se décharge par un trajet passant par l'enroulement secondaire W2, la diode D3 et l'interrupteur M3, et la résistance rₘ. Le transistor M3 étant bloqué en l'absence de court-circuit, le branchement en parallèle de la diode D3 et du transistor M3 n'affecte pas le fonctionnement à l'ouverture et à la fermeture du circuit tel que décrit précédemment.

Par ailleurs, la décharge de la grille du transistor de puissance Tp en cas de court-circuit n'intervient pas pendant la présence d'une impulsion de mise en conduction du transistor Tp, mais immédiatement après de telles impulsions. De plus, il est prévu un circuit masquant la tension aux bornes de la résistance rₘ pendant la charge de la capacité de grille du transistor Tp. Dans le mode de réalisation représenté, ce circuit de masquage de la résistance rₘ comprend un transistor MOS à canal N M4 en série avec une résistance R4 et une diode D4, l'ensemble étant en parallèle sur la résistance rₘ. La grille du transistor M4 est reliée par un transistor M5 à la borne supérieure de l'enroulement secondaire W2 et par une résistance R6 à la borne de référence des transistors T1 et Tp. La grille du transistor M5 est reliée à la grille du transistor Tp et une impédance R5 est disposée entre grilles et source du transistor M5. Ainsi, dès qu'un courant de charge de la capacité de grille du transistor Tp circule de la borne supérieure de l'enroulement W2 à la grille du transistor Tp, c'est-à-dire au cours d'un ordre de fermeture, une tension se développe sur la résistance R5 et une tension négative se développe sur la grille du transistor à canal P M5 qui devient passant et provoque le passage d'un courant dans la résistance R6 et la conduction du transistor M4. Il en résulte le masquage de la résistance rₘ pendant le passage dans le transistor Tp de pics de courant consécutifs au recouvrement des diodes de roue libre en parallèle sur la charge lors de la fermeture du transistor Tp. Dès que la charge de la capacité de grille du transistor Tp est terminée, les transistors M5 et M4 se bloquent, et la tension aux bornes de la résistance rₘ est susceptible de commander le transistor M3 de la façon décrite précédemment pour provoquer la décharge de la grille du transistor Tp.

En outre, on a représenté sur la figure divers éléments accessoires destinés à favoriser le bon fonctionnement du circuit. Parmi ces éléments, on pourra noter une diode zener Z1 entre grille et source du transistor T1. Cette diode zener Z1 est essentiellement destinée à éviter d'appliquer des tensions trop élevées sur cette grille au début des impulsions d'ouverture. En parallèle entre la grille et la source du transistor M3 on trouve un condensateur C3 et une résistance R3. L'ensemble du condensateur C3, de la résistance R3 et de la diode D4 est destiné à assurer la présence d'une constante de temps pour laisser le transistor MOS M3 fermé suffisamment longtemps après détection d'une surtension pour décharger complètement le transistor Tp. Une diode D5 est en parallèle sur la résistance R5 pour réduire l'impédance du trajet de décharge de la grille du transistor Tp.

Ainsi, le circuit de la figure 3 permet de détecter grâce à la résistance rₘ l'apparition d'un court-circuit dans la charge, et de décharger la capacité de grille du transistor Tp à travers la diode D3, l'interrupteur M3 et le secondaire W2 dès qu'une surtension se manifeste. Cette décharge de la capacité de grille du transistor Tp se traduit par la passage d'une impulsion de courant négative dans l'enroulement secondaire W2. Si l'on détecte au primaire cette impulsion négative, on obtiendra une indication du fait qu'un court-circuit s'est produit et l'on pourra ainsi actionner une alarme, cesser d'envoyer des ordres de fermeture et confirmer l'état ouvert par un ordre d'ouverture.

Un autre circuit habituel de détection de court-circuit pourra être utilisé pour commander M3. Ce circuit surveille la tension sur le collecteur de Tp au lieu de surveiller le courant dans rₘ. En cas de court-circuit, la tension collecteur/émetteur de Tp est anormalement élevée, et peut être utilisée par tout moyen connu de l'homme de l'art pour actionner la grille de M3 à la fin de l'impulsion de fermeture, et provoquer la décharge de Tp dans W2, permettant d'actionner le circuit d'alarme.

La figure 4 représente un exemple de circuit de commande de l'enroulement primaire W1 associé à l'enroulement W2 précédemment mentionné, ce circuit permettant en outre de détecter l'apparition d'une impulsion de courant négative sur l'enroulement W2 alors que le transistor Tp est normalement dans l'état passant, cette impulsion de courant se traduisant par une impulsion négative correspondante sur l'enroulement W1.

Le circuit de commande de l'enroulement primaire W1 illustré en figure 4 est un montage en pont comprenant quatre branches 11 à 14 comprenant chacune un interrupteur en parallèle avec une diode de retour. Une première diagonale du pont est reliée entre une alimentation VCC et la masse GND. L'enroulement primaire W1 est placé sur la deuxième diagonale du pont. Avec les notations de la figure, une impulsion d'une première polarité, résultant de la mise à l'état passant des interrupteurs 12 et 13 correspondant à une impulsion de fermeture, et une impulsion d'une deuxième polarité résultant de la fermeture des interrupteurs 11 et 14 correspond à la fourniture d'une impulsion d'ouverture. En ce cas, pendant que l'on est dans l'état de fermeture, après la fourniture de l'impulsion de première polarité, les interrupteurs 13 et 14 doivent être passants, les interrupteurs 11 et 12 étant bloqués. C'est dans cet état que l'on veut détecter l'éventuelle apparition d'une impulsion négative sur l'enroulement W1, résultant d'un court-circuit dans la charge et de la décharge de la grille du transistor Tp. Pour cela, on dispose une impédance 15 constituée par exemple de deux diodes en anti-parallèle dans la branche du pont comprenant le commutateur 13. On pourra alors facilement déterminer par des moyens classiques l'apparition d'une tension de polarité déterminée, correspondant à ladite impulsion négative sur l'enroulement W1, apparaissant sur l'impédance 15. Cette détection pourra être utilisée pour commander une alarme et confirmer l'état ouvert du commutateur de puissance.

L'homme de l'art pourra imaginer diverses variantes de réalisation des circuits selon la présente invention, l'essentiel étant que les fonctions indiquées pour chacun de ces circuits soient satisfaites.

Dans les revendications ci-après le verbe "relier" est utilisé pour désigner une connexion entre deux composants avec interposition éventuelle d'autres composants et le verbe "connecter" pour désigner une connexion qui peut être directe.

## Revendications

1. Circuit de commande par impulsions d'un transistor de puissance à grille isolée (Tp) comprenant une première borne, de grille, et une deuxième borne, de référence, un transistor MOS auxiliaire (T1) étant connecté entre lesdites première et deuxième bornes et un secondaire de transformateur d'impulsions (W2) ayant des troisième et quatrième bornes étant relié aux première et deuxième bornes respectivement, une première diode (D) connectée entre les deuxième et quatrième bornes, caractérisé en ce qu'il comprend en outre :
deux voies en parallèle à conduction unidirectionnelle commandée (D1, M1 ; D2, M2), entre la quatrième borne et la grille du transistor auxiliaire, ces voies étant alternativement rendues passantes quand une impulsion positive ou négative est appliquée sur le secondaire du transformateur, chacune desdites voies comprenant respectivement une deuxième et une troisième diode (D1, D2) en série avec un premier et un deuxième transistor MOS (M1, M2), les deux diodes étant connectées en anti-parallèle, les deux transitors MOS étant de canal de type de conductivité opposé, leurs grilles étant interconnectées et reliées à ladite troisième borne.

2. Circuit de commande selon la revendication 1, comprenant en outre des moyens d'interruption de la conduction du transistor de puissance quand sa charge est en court-circuit, caractérisé en ce que lesdits moyens d'interruption comprennent un chemin (D3, M3) en parallèle avec ladite première diode (D), ce chemin étant mis en conduction quand le courant dans le transistor de puissance dépasse une intensité prédéterminée ou que la chute de tension à l'état passant dans le transistor de puissance dépasse une valeur prédéterminée.

3. Circuit de commande selon la revendication 2, caractérisé en ce que ledit chemin comprend une quatrième diode (D3) tête-bêche par rapport à la première diode (D), et un troisième transistor MOS (M3) dont la grille est connectée à l'électrode de référence du transistor de puissance, cette électrode de référence étant connectée à ladite deuxième borne par l'intermédiaire d'une résistance de mesure (rₘ).

4. Circuit de commande selon la revendication 2, caractérisé en ce qu'il comprend des moyens (M4, M5, R5, R6) d'inhibition de la mise en conduction dudit chemin pendant la charge de la capacité de grille du transistor de puissance.

5. Circuit de commande selon la revendication 4, caractérisé en ce que les moyens d'inhibition comprennent un quatrième et un cinquième transistors MOS, le quatrième transistor MOS (M4) étant connecté aux bornes de la résistance de mesure par l'intermédiaire d'une autre résistance (R4), le cinquième transistor MOS (M5) étant connecté entre la grille du quatrième transistor MOS et ladite troisième borne, la grille du cinquième transistor MOS étant connectée à la première borne et une impédance étant connectée entre les première et troisième bornes.

6. Circuit de commande selon la revendication 2, caractérisé en ce que le primaire dudit transformateur est associé à un circuit de détection de passage d'une impulsion de décharge de capacité grille/électrode du transistor de puissance dans le secondaire du transformateur par suite de la fermeture dudit chemin.

7. Circuit de commande selon la revendication 6, caractérisé en ce que le primaire du transformateur est alimenté par un montage en pont, ledit circuit de détection étant associé à une branche du pont qui est à l'état passant après que le transistor de puissance a été commandé par une impulsion pour être à l'état passant.

## Patentansprüche

1. Pulsgesteuerte Schaltung für einen Leistungstransistor (Tp) mit einem isolierten Gate, mit einem ersten Gate-Anschluß und einem zweiten Referenzanschluß, mit einem MOS-Hilfs-Transistor (T1) verbunden zwischen dem ersten und zweiten Anschluß, und wobei die Sekundärseite eines Impulstransformators (W2) dritte und vierte Anschlüsse gekoppelt mit den ersten bzw. zweiten Anschlüssen aufweist, wobei eine erste Diode (D) zwischen dem zweiten und vierten Anschluß geschaltet ist, dadurch gekennzeichnet, daß die Schaltung ferner folgendes aufweist:
zwei gesteuerte in einer Richtung leitende parallele Pfade (D1, M1; D2, M2) zwischen dem vierten Anschluß und dem Hilfstransistorgate, wobei die Pfade relativ leitend gemacht werden, wenn ein positiver oder negativer Impuls an die Sekundärseite des Transformators angelegt wird, wobei die Pfade jeweils eine zweite und eine dritte Diode (D1, D2) in Serie mit einem ersten und einem zweiten MOS-Transistor (M1, M2) aufweisen, wobei die zweiten und dritten Dioden antiparallel geschaltet sind, und wobei ferner diese MOS-Transistoren gegensätzlicher Kanalbauart sind und ihre Gates miteinander und mit dem dritten Anschluß verbunden sind.

2. Steuerschaltung nach Anspruch 1, wobei ferner Mittel zum Unterbrechen der Leitung des Leistungstransistors, wenn seine Last kurzgeschlossen ist, vorgesehen ist, wobei die Unterbrechungsmittel einen Pfad (D3, M3) parallel zur ersten Diode (D) aufweisen, wobei der Pfad eingeschalten wird, wenn der Strom im Leistungstransistor eine vorbestimmte Stärke oder Intensität übersteigt oder wenn der Spannungsabfall im leitenden Zustand im Leistungstransistor einen vorbestimmten Wert übersteigt.

3. Steuerschaltung nach Anspruch 2, wobei der Pfad eine vierte Diode (D3) aufweist, die umgekehrt bezüglich der ersten Diode (D) geschaltet ist und ferner mit einem dritten MOS-Transistor (M3), wobei dessen Gate mit der Referenz- oder Bezugselektrode des Leistungstransistors verbunden ist, wobei die Bezugselektrode mit dem zweiten Anschluß über einen Meßwiderstand (rm) verbunden ist.

4. Steuerschaltung nach Anspruch 2, mit Mitteln (M4, M5, R5, R6) zum Sperren des Leitens des erwähnten Pfades, während des Ladens der Leistungstransistor-Gate-Kapazität.

5. Steuerschaltung nach Anspruch 4, wobei die Sperrmittel einen vierten und einen fünften MOS-Transistor aufweisen, von denen der vierte MOS-Transistor (M4) mit den Anschlüssen des Meßwiderstandes über einen weiteren Widerstand (R4) verbunden ist, während der fünfte MOS-Transistor (M5) zwischen das Gate des vierten MOS-Transistors und den dritten Anschluß geschaltet ist, wobei das Gate des fünften MOS-Transistors mit dem ersten Anschluß verbunden ist und eine Impedanz zwischen die ersten und dritten Anschlüsse geschaltet ist.

6. Steuerschaltung nach Anspruch 2, wobei die Primärseite des Transformators mit einer Schaltung in Beziehung steht oder mit dieser verbunden ist zum Detektieren des Durchgangs eines Entladungsimpulses der Gate/Elektrodenkapazität des Leistungstransistors (Tp) in der Sekundärseite des Transformators infolge des Schließens dieses Pfades.

7. Steuerschaltung nach Anspruch 6, wobei die Primärseite des Transformators durch eine Brückenschaltung oder -verbindung gespeist wird, wobei die Detektionsschaltung mit einem Zweig der Brücke assoziiert oder verbunden ist, die sich in dem leitenden Zustand befindet sobald der Leistungstransistor durch einen Impuls in den leitenden Zustand gesteuert ist.

## Claims

1. A pulse-controlled circuit for a power transistor (Tp) with an insulated gate, having a first gate terminal and a second reference terminal, an auxiliary MOS transistor (T1) connected between said first and second terminals and the secondary of a pulse transformer (W2) having third and fourth terminals coupled to the first and second terminals, respectively, a first diode (D) connected between said second and fourth terminals, characterized in that it further comprises:
two controlled unidirectionally conductive paths in parallel (D1, M1; D2, M2), between said fourth terminal and said auxiliary transistor gate, said paths being alternatively rendered conductive when a positive or negative pulse is applied to said secondary of the transformer, wherein said paths respectively comprise a second and a third diode (D1, D2) in series with a first and a second MOS transistor (M1, M2), said second and third diodes being anti-parallel connected, said MOS transistors being of the opposite channel-type, their gates being interconnected and coupled to said third terminal.

2. A control circuit according to claim 1, further comprising means for interrupting the conduction of the power transistor when its load is shorted, wherein said interruption means comprise a path (D3, M3) in parallel with said first diode (D), said path being switched on when the current in the power transistor exceeds a predetermined intensity or when the voltage drop at the conductive state in said power transistor exceeds a predetermined value.

3. A control circuit according to claim 2, wherein said path comprises a fourth diode (D3) reversely connected with respect to said first diode (D) and a third MOS transistor (M3), the gate of which is connected to the reference electrode of the power transistor, said reference electrode being connected to said second terminal through a measure resistor (rₘ).

4. A control circuit according to claim 2, comprising means (M4, M5, R5, R6) for inhibiting the conduction of said path during charging of the power transistor gate capacitance.

5. A control circuit according to claim 4, wherein said inhibition means comprise a fourth and a fifth MOS transistor, said fourth MOS transistor (M4) being connected to the terminals of said measure resistor through a further resistor (R4), said fifth MOS transistor (M5) being connected between the gate of said fourth MOS transistor and said third terminal, the gate of said fifth MOS transistor being connected to said first terminal and an impedance being connected between said first and third terminals.

6. A control circuit according to claim 2, wherein the primary of said transformer is associated with a circuit for detecting the passage of a pulse discharging the gate/electrode capacitance of the power transistor Tp in the secondary of the transformer further to the switching on of said path.

7. A control circuit according to claim 6, wherein the primary of the transformer is energized by a bridge connection, said detection circuit being associated with a leg of the bridge which is at the conductive state once the power transistor has been controlled through a pulse to be in the conductive state.
